Europäisches Patentamt

European Patent Office

Office européen des brevets

(11) Publication number: **0 367 522**
**A2**

# EUROPEAN PATENT APPLICATION

(21) Application number: 89311161.7

(51) Int. Cl.5 **H03M 1/50**

(22) Date of filing: 30.10.89

(30) Priority: 02.11.88 US 266047

(43) Date of publication of application:
**09.05.90 Bulletin 90/19**

(84) Designated Contracting States:
**DE FR GB**

(71) Applicant: **Hewlett-Packard Company**
**3000 Hanover Street**
**Palo Alto California 94304(US)**

(72) Inventor: **Baumgartner, Richard A.**
**1860 Newell Road**
**Palo Alto, CA94303(US)**

(74) Representative: **Williams, John Francis et al**
**J.F. Williams & Co 34 Tavistock Street**
**London WC2E 7PB(GB)**

(54) **Closed loop pulse width analog-to-digital converter.**

(57) An A/D converter which is well suited to the conversion of low level and low frequency analog input signals incorporates a pulse width modulator (30) coupled with a pulse width counter (44) in a feedback loop such that the linearity and distortion of the pulse width modulator are feedback-regulated and non-critical. The pulse width modulator oversamples the input voltage by a factor of two with the output of the pulse width counter being digitally filtered to extract two additional bits of resolution.

EP 0 367 522 A2

## CLOSED LOOP PULSE WIDTH ANALOG-TO-DIGITAL CONVERTER

The present invention relates to analog-to-digital (A D) converters, and more particularly is directed to an A D converter that is well suited to the conversion of analog input signals that have a low amplitude and or a low frequency.

In many instances it is desirable to be able to reliably and accurately convert low amplitude or low frequency analog signals into a digital format. For example, in the field of medical technology, it is desirable to convert low level biological signals, such as electro-cardiogram waveforms, into digital signals for analysis or further processing. Presently known A D converters are not well suited for the conversion of such low level signals, however. Representative examples of such presently known converters are the dual slope converter, an open loop pulse width modulator with a pulse width counter, and a sigma delta modulator. Each of these converters has certain limitations when it comes to the conversion of low level or low frequency analog signals.

The dual slope converter operates in three-phase cycles. During each cycle one of a zero input, an unknown input, and a reference input, respectively, are connected to an integrator. During an initial auto-zero phase, an offset is determined which, when added to the zero input, will result in a zero output. During a second input phase, the unknown signal is connected to the integrator for a period of time sufficient for an output counter to be incremented from zero to full-range. During a final comparison phase, the integrator is discharged by a reference of polarity opposite that of the unknown signal while the counter is decremented until the integrator voltage is reduced to its starting auto-zeroed level. Although the dual slope converter is easily auto-zeroed, such auto-zeroing is obtained only at the price of additional circuit complexity and slower cycle time. In particular, the unknown input signal is not continuously sampled during the operation of the dual slope converter. Rather, because of the need to auto-zero the converter during each cycle, the input signal is sampled only during one of the three phases of each cycle.

In the pulse width modulator with pulse width counter, the unknown signal to be converted is compared to a generated triangle wave and a pulse is produced which has a width equal to the time between successive crossings of the unknown wave form and the triangle wave. This pulse causes a digital counter to be advanced for the duration of the pulse. This type of converter is open loop, and therefore the linearity, distortion, and offset of the triangle wave are critical since they determine the characteristics of the converter.

Such a situation is particularly undesirable for realization in integrated circuit form where reducing sensitivity to just a few key value ratios or external reference voltages is necessary.

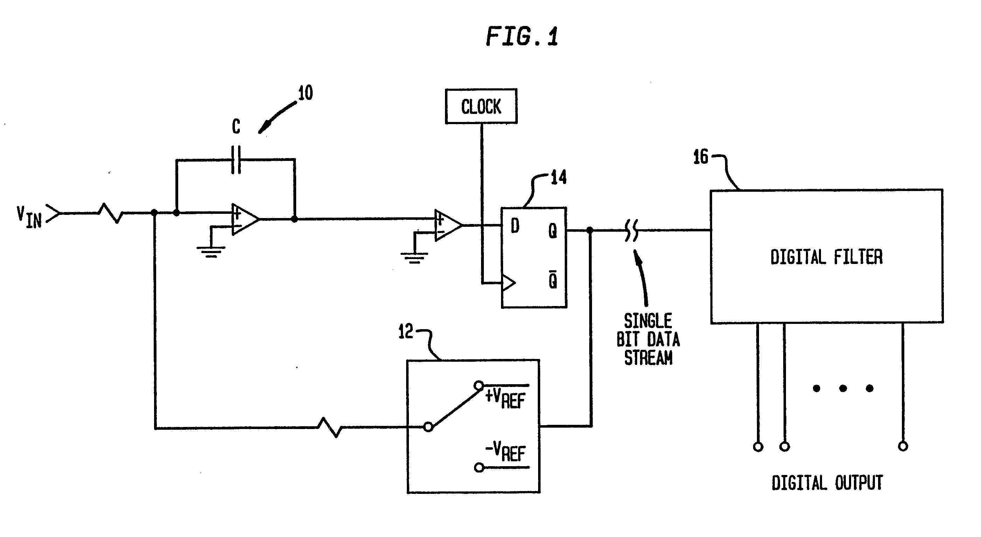

A sigma delta modulator circuit is shown in Figure 1. This circuit includes an integrator 10 having a feedback loop with a reference voltage selector 12 which operates to keep the average charge in an integrating capacitor C of the integrator at zero. The reference voltage selector 12 is controlled by the output Q of a flip-flop 14. When the input voltage is zero, the output Q of the flip-flop is at each of its binary values an equal amount of time. When an input signal is applied, the reference voltage is controlled such that one reference polarity predominates over the other, such predominance information being extracted by a digital filter 16. In the circuit of Figure 1, slight asymmetries in the reference levels $+V_{ref}$ and $-V_{ref}$ from the voltage selector 12 result in undesirable noise and distortion, which is too great for the conversion of low level input signals. Furthermore, the sigma delta modulator exhibits inherent nonlinearities, and extensive digital filtering is required to extract the predominance information on which the digital output is based.

According to the present invention, an A/D converter which is well suited to the conversion of low level and low frequency analog input signals incorporates a pulse width modulator in a feedback loop of an integrator such that the linearity and distortion of the pulse width modulator are feedback-regulated and non-critical. A counter receives a synchronized pulse-width modulated signal to produce an N-bit digital output signal representative of the magnitude of an analog input signal. The pulse width modulator can over-sample the input voltage by a selected factor "$\ell$", with the output of the pulse width counter being digitally filtered to extract "$\ell$" additional bits of resolution. In one embodiment of the invention, the selected factor "$\ell$" is equal to two. Such filtering is much simpler than that required by a sigma delta converter of the same resolution, thus requiring far fewer co-efficients.

Figure 1 is a block circuit diagram of a sigma delta modulating converter of the prior art;

Figure 2 is a block diagram of a conversion system of the type in which an A/D converter of the present invention might be suitably employed;

Figure 3 is a block circuit diagram of a closed loop pulse width analog-to-digital converter in accordance with the present invention; and

Figures 4a-4c are timing diagrams illustrating the operation of the A/D converter of the present invention.

In the following description of a preferred embodiment of the present invention and examples of its operation, reference may be made to the conversion of low level and/or low frequency analog input signals into a digital format to facilitate an understanding of the invention and its applications. It will be appreciated, however, that the utility of the invention is not limited to these particular applications. Rather, the invention can be used in a variety of different environments where the reliable and accurate conversion of analog input signals into a digital form is required.

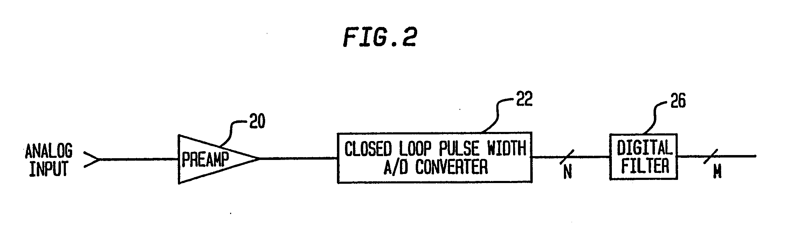

Referring now to Figure 2, an overall A/D conversion system, of the type to which the A/D converter of the present invention is applicable, is illustrated in block diagram form. This type of conversion system might be particularly suited for use in a biomedical environment, for example. The conversion system includes a preamplifier 20, a closed loop pulse width A/D converter 22, and a digital filter 26 respectively connected in a sequential manner as shown. The preamplifier 20 scales an analog input signal to bring it within a range suitable for conversion, for example in a range from -50 mV to +50 mV. The A/D converter 22 produces an N-bit digital output signal representative of the magnitude of the analog input signal. In a preferred embodiment of the invention, the A/D converter 22 is operated in an oversampling mode such that the serial bit stream fed into the digital filter 26 is of a greater bandwidth than that required to accurately represent the analog input signal. By appropriate digital filtering, this extra bandwidth is translated into M-N additional bits of resolution to arrive at a final M-bit output signal.

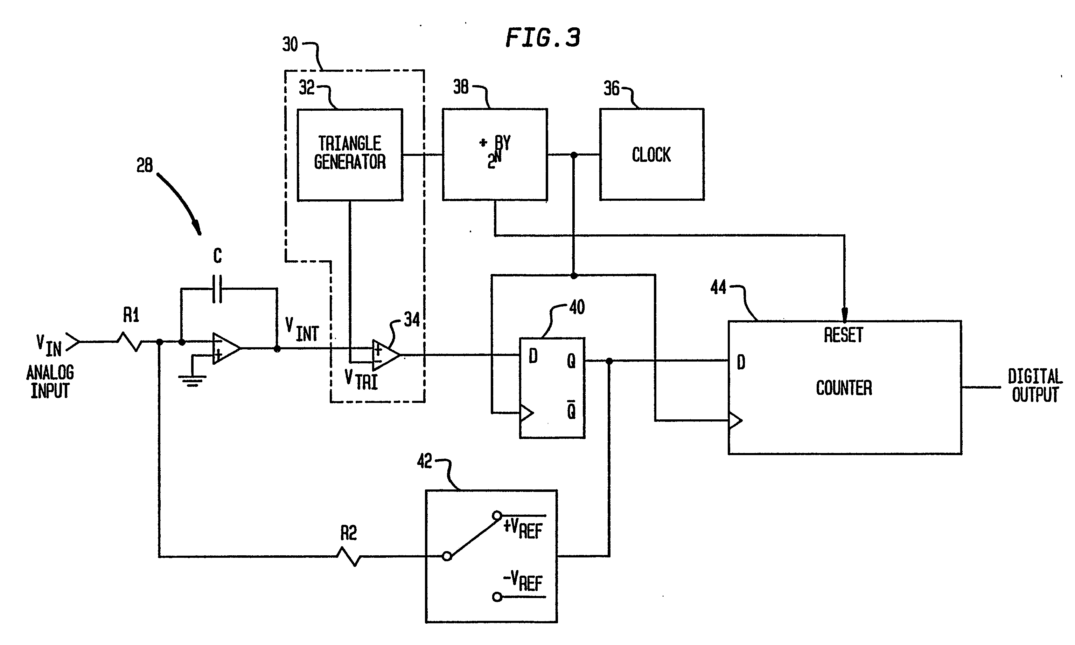

Figure 3 shows in greater detail the construction of the closed loop pulse width A/D converter of Figure 2. The analog input signal to be converted into digital form is applied through a resistor R1 to an input terminal of an integrator 28 having a feedback integrating capacitor C. Preferably, the integrator is of the type which utilizes a chopper stabilization technique to reduce input offsets to an insignificant value. The output signal of the integrator is fed to a pulse width modulator 30 which includes a comparator 34 that receives the integrator signal at one input terminal and the output signal from a triangle waveform generator 32 at its other input terminal. The period of the waveform from the triangle generator is determined by the frequency of a system clock 36 which is divided in a frequency divider 38.

The output signal from the pulse width modulator, i.e. from the comparator 34, is a pulse train in which the width of the individual pulses are modulated by the magnitude of the analog input signal to the integrator 28. The transitions of the pulse width modulator output signal are synchronized to the system clock 36 by a D-type flip-flop 40 which is clocked by the system clock 36 and receives the pulse width modulated signal at its data input terminal. The flip-flop 40 functions as a quantizer, establishing the reciprocal of the system clock frequency as the smallest unit of time to be considered in converting from the continuous analog domain to the discrete digital domain. According to the quantized output of the pulse width modulator 30, a positive or negative feedback voltage $\pm V_{ref}$ is selected by a reference voltage selector 42 and applied to the input terminal of the integrator 28 through a resistor $R_2$. The net effect of the quantized output signal is to balance the current delivered by the input signal over one period of the triangle wave.

The quantized value from the flip-flop 40 is also applied to the data input terminal of a counter 44 which is also clocked by the system clock 36. This counter is periodically reset by the frequency divided signal from the divider 38. The divisor $2^N$ of the frequency divider 38 determines the number of bits N of hardware resolution. In a preferred embodiment, N = 10.

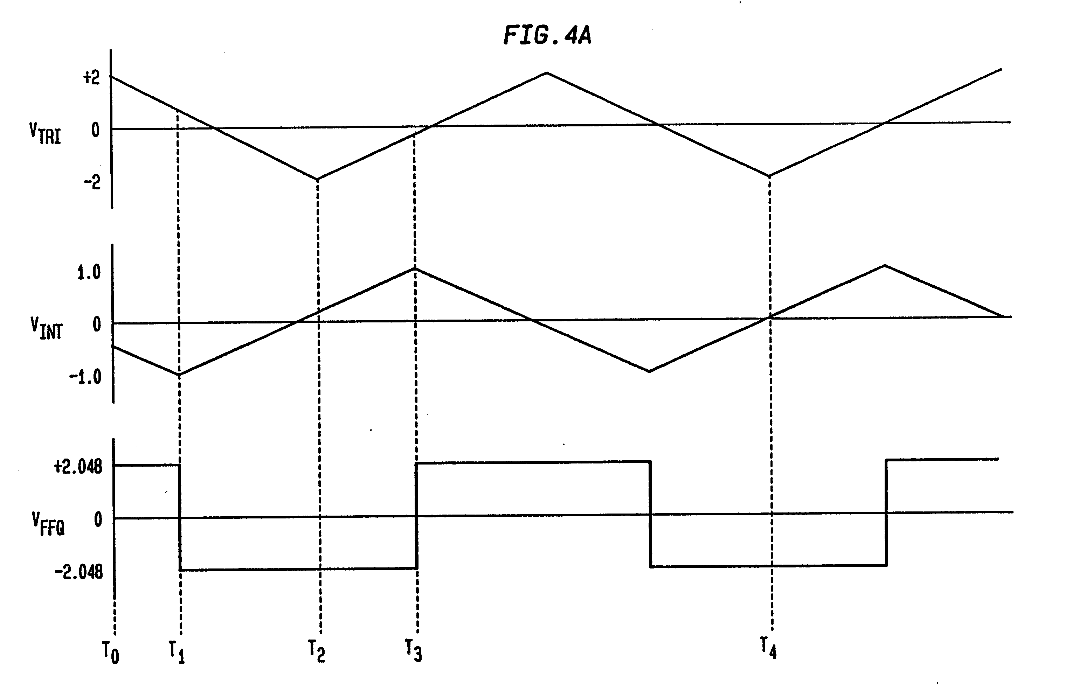

The operation of the A/D converter shown in Figure 3 is explained with reference to the timing diagrams illustrated in Figures 4a-4c. The case in which the input signal is at zero volts is depicted in Figure 4a. In this situation the current through the integrating capacitor C is identical to the current through the resistor $R_2$. When the $+V_{ref}$ feedback voltage is selected, the current is of a magnitude in one direction and when the $-V_{ref}$ voltage is selected, the current is of an equal magnitude in an opposite direction. Since the average current output from the integrator must be zero for this case, $+V_{ref}$ and $-V_{ref}$ are selected in equal duration. Hence, the integrator output signal $V_{INT}$ becomes a symmetric saw-tooth waveform of a periodicity identical to that of the triangle waveform $V_{TRI}$.

Referring to Figure 4a, at time $t_0$ the triangle waveform generator 32 begins a new cycle, with its output signal decreasing in value from maximum, e.g. 2 volts. In the illustrated example it is assumed that the reference voltage generator 42 is producing the negative output voltage. Since the analog input signal VIN is zero, the output signal $V_{INT}$ of the integrator 28 is equal to the integrated value of the reference voltage signal. At time $t_0$ the value of $V_{INT}$ is greater then the inverted value of the triangle voltage, and hence the comparator 34 produces a true, e.g. logic one, output signal. The comparator, and hence the flip-flop 40, remain in this state until time $T_1$, when the inverted value of the triangle voltage becomes greater (less negative) than $V_{INT}$. At this time the comparator output signal changes state and the flip-flop follows on the next succeeding clock cycle. This causes the output voltage of the reference generator 42 to switch to the positive polarity, as a result of which the integrator output signal $V_{INT}$ begins to increase. At time $t_2$ the triangle waveform switches and begins to increase in value. However, at this time its inverted value is still greater than the output voltage of the integrator, and so the comparator is not switched. This state remains until time $t_3$, when the integrator output voltage becomes greater in value than the inverted value of the triangle voltage.

The resulting pulse width modulated output signal of the comparator 34 is a square wave of 50% duty cycle as shown in Figure 4a. The counter 44 is reset during each cycle of the triangle waveform, e.g. at times $t_2$, $t_4$, etc. This operation causes the counter to count up to approximately the midpoint of its operating range during each period. This count can be stored in a suitable latch (not shown) that is triggered each time the counter is reset.

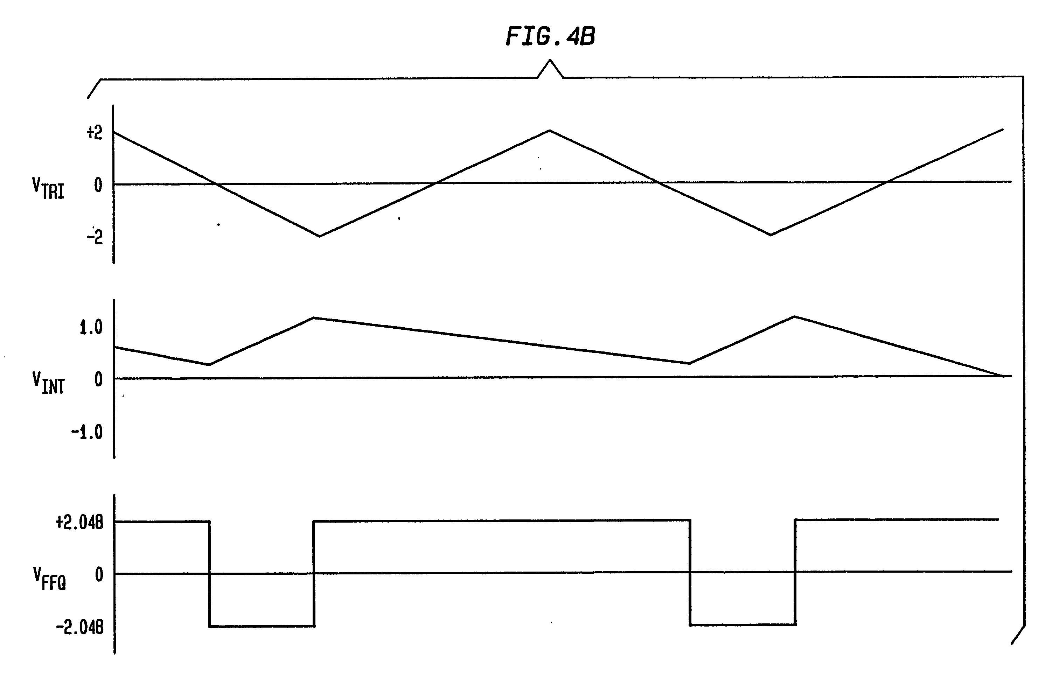

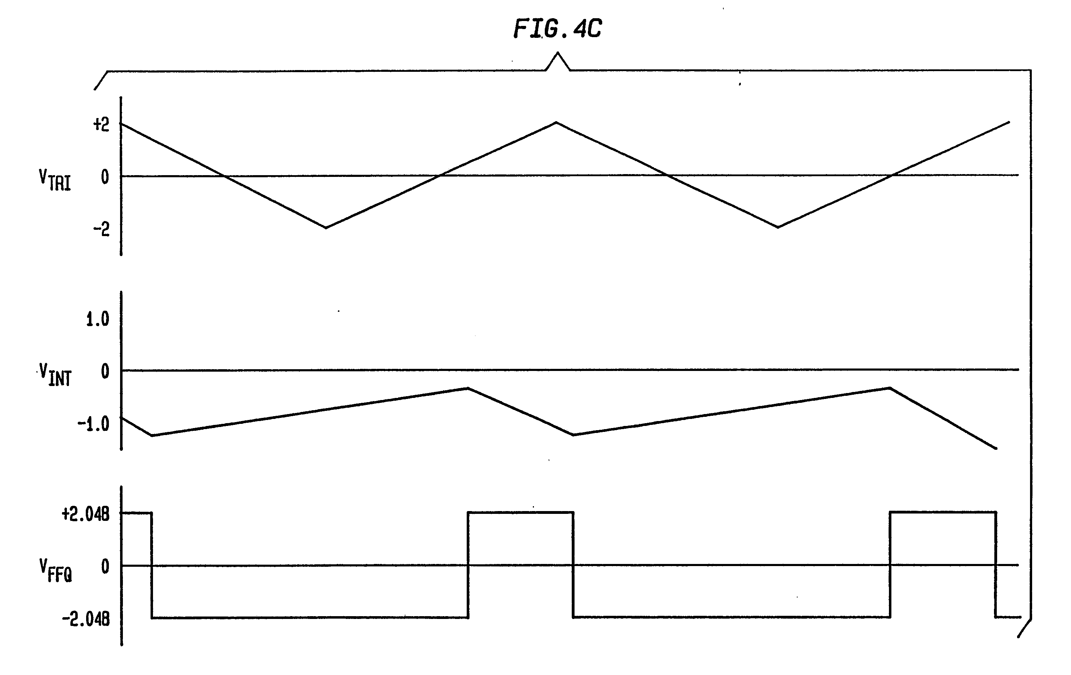

When the analog input signal $V_{IN}$ is positive, the operation of the converter is as depicted in Figure 4b. The effect of this positive input voltage is the same as if $+V_{ref}$ were boosted above its normal level with respect to $-V_{ref}$. As a result, $+V_{ref}$ is selected a proportionally smaller amount of time and the pulse width modulated output is as shown in Figure 4b, causing counter 44 to count up a proportionally greater amount of the time. With the analog input voltage $V_{IN}$ negative, operation is complementary to that just described, as shown in Figure 4c.

In lieu of the arrangement of the pulse width modulator 30 depicted in Figure 3, the input terminals to the comparator 34 can be connected across a resistor. The negative comparator input is grounded. The positive input is in turn connected to two other resistors that respectively lead to the integrator 28 and the triangle. generator 32 at a common voltage summing node therebetween. In a preferred embodiment of the invention, the resistors all have the same value.

The frequency response characteristics of the A/D converter are controlled by a dominant pole determined by the values of the capacitor C of the integrator 28 and the resistor $R_2$. If the RC time constant seen by the pulse width modulator, as determined by these two components, becomes too short, the Nyquist sampling criterion in the pulse width modulator may be violated. In such a case, the operation of the A/D converter will be similar to that of a sigma-delta modulator, such as that shown in Figure 1. By appropriately selecting the values of the capacitor C and the resistor $R_2$ to produce a sufficiently large time constant, the A/D converter will be endowed with frequency stability. The precise values for the capacitor C and the

resistor $R_2$ which will achieve this result can be empirically determined in view of the particular subelements of the A/D converter which are selected for a particular embodiment.

Although the N-bit output signal of the pulse width counter may be taken as the final output of the A/D converter, the resolution of the converter may be conveniently increased through the technique of oversampling. Assuming an upper cut-off frequency of the integrator to be f. the output of the integrator may be faithfully reproduced according to the Nyquist criterion by sampling the output of the integrator with the triangle wave at a frequency of at least 2f. By setting the frequency of the triangle wave at 4f, additional information-bearing signal bandwidth is obtained that may subsequently be traded off for additional bits of resolution. As noted previously, the resolution of the digital output signal is determined by the divisor for the frequency divider. In a preferred embodiment that is suitable for use in biomedical applications, 4f is taken to be approximately 4.88 KHz, and this sampling rate is subsequently digitally filtered down to a bandwidth of 500 Hz with an accompanying gain of 2 bits in resolution.

The maximum input voltage excursion of the converter is determined by the reference voltage times $R_1/R_2$. The long-term stability of the converter is determined by the same ratio together with the stability of the reference voltages and the ability of the integrator to maintain a near-zero input offset.

Because the pulse width modulator is coupled in the feedback loop of the integrator, any asymmetry, non-linearity or distortion which it may exhibit are inherently regulated and are not critical to the overall linearity and distortion of the converter. Among other advantages, the overall simplicity of the converter readily facilitates its implementation in integrated circuit form. Further, since the output of the converter is determined in an accumulator, i.e. the counter, relatively simple digital filtering may be employed to increase output resolution as compared with the complex filtering required to extract the digital representation of the input from a raw serial bit stream. Multiple channels may be accommodated by sharing the triangle waveform generator, the frequency divider, and the system clock among all of the channels and replicating the remainder of the circuit for each channel.

## Claims

1. An analog-to-digital (A/D) converter comprising:

integrating means (28) receiving an analog input signal $V_{IN}$) and producing an integrated output signal ($V_{INT}$) related to said analog input signal; pulse-width modulating means (30) receiving said integrated output signal and producing a pulse output having a duty cycle substantially proportional to a parameter of said analog input signal; means for generating a clock signal (36); and a counter (44) responsive to said pulse output for counting said clock signal to produce a digital count value representative of said parameter of said analog input signal; characterised in that the converter further comprises reference signal generating means (42) responsive to said pulse output and connected in a feedback loop to an input terminal of said integrating means to provide a reference signal ($V_{REF}$) to said integrating means that is dependent upon pulse output.

2. The A/D converter of Claim 1 in which said pulse width modulating means comprises: a triangle-wave generator (32); and a comparator (34) receiving an output ($V_{TRI}$) of said triangle-wave generator and receiving said integrated output signal ($V_{INT}$) and producing a comparison result output that is one polarity when said triangle-wave output is lesser in magnitude than said integrated output and another polarity when said triangle-wave output is greater in magnitude.

3. The A/D converter of Claim 2 further comprising a flip-flop (40) for receiving said comparison result output and clocked by said clock signal generating means (36) to produce said pulse output having a polarity the same as the polarity of said comparison result and synchronised with said clock signal.

4. The A/D converter of Claim 3 further comprising: pulse dividing means (38) for dividing said clock signal by $2^N$ to produce a reduced clock, and providing said reduced clock to said triangle-wave generator (32), to thereby synchronise said clock signal generating means (36) with said triangle-wave generator.

5. The A/D converter of Claim 4 in which said reduced clock is provided to said counter (44) to reset said counter.

6. The A/D converter of any preceding claim in which said counter (44) is an N-bit counter.

7. The A/D converter of any of claims 2 to 6 in which the frequency of a triangle waveform ($V_{TRI}$) produced by said triangle-wave generator (32) is greater than twice an effective bandwidth of said integrating means (28).

8. The A/D converter of Claim 7 in which the frequency of said triangle waveform ($V_{TRI}$) is at least four times said effective bandwidth.

9. The A/D converter of any preceding claim in which said integrating means (28) is chopper-stabilised such that when no input signal is applied to said integrating means, the output of said integrating means ($V_{INT}$) has virtually no D. C. com-

ponent.

FIG. 1

FIG.2

ANALOG INPUT

PREAMP
20

CLOSED LOOP PULSE WIDTH A/D CONVERTER
22

N

DIGITAL FILTER
26

M

FIG.3

DIGITAL OUTPUT

COUNTER

RESET

44

D

CLOCK

36

$\div$ BY $2^N$

38

40

D

Q

$\bar{Q}$

TRIANGLE GENERATOR

32

34

$V_{TRI}$

30

$V_{INT}$

C

42

$+V_{REF}$

$-V_{REF}$

R2

28

R1

$V_{IN}$

ANALOG INPUT

## FIG.4A

EP 0 367 522 A2

FIG.4B

EP 0 367 522 A2

FIG.4C

$V_{TRI}$   +2   0   -2

$V_{INT}$   1.0   0   -1.0

$V_{FFQ}$   +2.048   0   -2.048